# EUROPÄISCHE PATENTANMELDUNG

(11) **EP 1 498 262 A1**
(43) Veröffentlichungstag der Anmeldung: **19.01.2005**
(21) Anmeldenummer: 03016055.0
(22) Anmeldetag: 15.07.2003
(51) Int. Cl.: B41C 1/14, B41N 1/24

(54) **Verfahren und Vorrichtung zur Herstellung einer Siebdruckschablone sowie Sieb mit einer Siebdruckschablone**

(71) Anmelder: Kesper Druckwalzen GmbH, 47809 Krefeld (DE)
(72) Erfinder: Kesper, Peter, 47800 Krefeld (DE)
(74) Vertreter: Schüll, Gottfried, Dipl.-Phys.

(57) **Zusammenfassung**

Die Erfindung betritt ein Verfahren bzw. eine Vorrichtung zur Herstellung einer Siebdruckschablone (2) für ein Sieb (3), insbesondere ein Rund- oder Flachsieb, wobei eine Maske (4) auf eine Trägerschicht (5) aufgebracht wird. Dabei besteht die Maske (4) zumindest im wesentlichen aus Tinte, die abschnittsweise auf die Trägerschicht (5) aufgetragen wird, wobei sich die Maske (4) aus Tinte mit der Trägerschicht (5) durch chemische Reaktion zu einer festen Gesamtschicht (6) verbindet. Nach dem Verbinden wird die Gesamtschicht (6) durch Waschen ausgespült. Dadurch wird eine Siebdruckschablone (2) schnell und mit geringem Aufwand hergestellt. Die Erfindung betrifft auch ein Sieb (3), insbesondere ein Rund- oder Flachsieb, mit einer entsprechenden Siebdruckschablone (2), die aus einer festen, aus einer Trägerschicht (5) und einer damit verbundenen Tintenschicht (4) gebildeten Gesamtschicht (6) besteht.

## Beschreibung

Die Erfindung betrifft ein Verfahren bzw. eine Vorrichtung zur Herstellung einer Siebdruckschablone für ein Sieb, insbesondere ein Rund- oder Flachsieb, wobei eine Maske auf eine Trägerschicht aufgebracht wird. Ferner betrifft die Erfindung ein Sieb, insbesondere ein Rund- bzw. Flachsieb, mit einer Siebdruckschablone.

Derartige Verfahren und korrespondierende Vorrichtungen sind aus dem Stand der Technik zur Herstellung von Siebdruckschablonen bekannt. Insbesondere sind dabei die direkte und die indirekte Methode zu nennen. Bei der direkten Methode wird als Trägerschicht eine lichtempfindliche Schicht auf das gespannte Siebgewebe aufgetragen. Diese Schicht wird dann mit einem kontrastreichen, photographischen Positiv oder Negativ, in der Regel aus Wachs oder Tinte, der gewünschten Siebdruckschablonenform abgedeckt und anschließend belichtet und entwickelt, wobei es zu einer Polymerisation kommt. Nach Entfernen der Maske werden entweder die belichteten oder die unbelichteten Bereiche der lichtempfindlichen Schicht durch Waschen des Siebes ausgespült, so dass im Ergebnis die gewünschte Siebdruckschablone auf der Oberfläche des gespannten Siebgewebes zurückbleibt.

Bei der indirekten Methode ist der Verfahrensablauf identisch mit dem der direkten Methode, mit dem Unterschied, dass die lichtempfindliche Trägerschicht zunächst noch nicht auf das Siebgewebe, sondern auf eine Folie, aufgebracht wird. Die nach dem Ausspülen auf der Folie zurückbleibende Siebdruckschablone wird dann unter leichtem Druck auf das gespannte Siebgewebe übertragen und getrocknet. Schließlich wird die Folie abgezogen und die Siebdruckschablone verbleibt auf dem Siebgewebe.

Nachteilig bei beiden Methoden ist der hohe Herstellungsaufwand der Siebdruckschablone bedingt durch die vielen, einzelnen Verfahrensschritte.

Von diesem Stand der Technik ausgehend liegt der vorliegenden Erfindung die Aufgabe zugrunde, ein Verfahren bzw. eine Vorrichtung zur Verfügung zu stellen, welches bzw. welche es ermöglicht, eine Siebdruckschablone für ein Sieb, insbesondere ein Rundoder Flachsieb, schnell und mit möglichst geringem Aufwand herzustellen. Der vorliegenden Erfindung liegt auch die Aufgabe zugrunde, ein entsprechendes Sieb mit einer Siebdruckschablone bereitzustellen.

Erfindungsgemäß wird die zuvor hergeleitete und aufgezeigte Aufgabe dadurch gelöst, dass die Maske zumindest im wesentlichen aus Tinte hergestellt wird, dass die Tinte abschnittsweise auf die Trägerschicht aufgetragen wird, wobei sich die Maske aus Tinte mit der Trägerschicht durch chemische Reaktion zu einer festen Gesamtschicht verbindet, und das nach dem Verbinden die Gesamtschicht durch Waschen ausgespült wird. Bei dem erfindungsgemäßen Verfahren wird also die Zusammensetzung der Trägerschicht und die Zusammensetzung der Tinte so gewählt, dass allein durch chemische Reaktion der Zusammensetzungen miteinander eine feste Gesamtschicht entsteht, die nach dem Auswaschen der nicht festgewordenen Abschnitte der Trägerschicht bereits die fertige Siebdruckschablone darstellt. Es ist dazu keine Polymerisation mehr erforderlich. Es ist auch nicht mehr zwingend erforderlich, die mit der Maske versehene Trägerschicht in einem separaten Verfahrensschritt mit UV-Licht oder dergleichen zu bestrahlen. Ein weiterer Vorteil ist, dass die Maske nicht mehr nach dem Belichtungsvorgang auf mühsame Weise von der Trägerschicht entfernt werden muss, sondern Bestandteil der Siebdruckschablone geworden ist. Da als Maske Tinte verwendet wird, die den Vorteil hat, dass sie sehr dünn aufgetragen werden kann, erhält man im Ergebnis nach wie vor eine Siebdruckschablone mit einer geringen Gesamtdicke. Vorteilhafterweise ist die Dicke der Trägerschicht kleiner als 10 µm und die Dicke der Tintenschicht größer als 30 µm. Würde man dagegen beim Stand der Technik nicht die Maske von der Trägerschicht entfernen, so wäre die Siebdruckschablone zu dick für die Verwendung bei einem Siebdruckverfahren.

Gemäß einer vorteilhaften Ausgestaltung ist vorgesehen, dass die Tinte EDV-gestützt aus mehreren Düsen auf die entsprechenden Abschnitte der Trägerschicht aufgespritzt wird. Das EDV-gestützte Aufspritzen ermöglicht bei der heute verfügbaren Antriebstechnik für die hierzu benötigten Druckköpfe eine höchstmögliche Flexibilität, da über das EDV-gestützte Aufspritzen jede beliebige in der EDV-Anlage gespeicherte Form der Maske gewählt und aufgespritzt werden kann. Besonders vorteilhaft ist es auch, dass mit dem erfindungsgemäßen Verfahren die Maske in einem einzigen Arbeitsgang auf die Trägerschicht aufgebracht werden kann.

Nach dem Aufspritzen der Tinte setzt unmittelbar die chemische Reaktion zwischen der Tinte und der Trägerschicht ein, d.h. die beiden Einzelschichten verbinden sich zu einer festen Gesamtschicht, die automatisch aushärtet und somit eine weitere Behandlung überflüssig macht. Es kann dennoch vorgesehen sein, dass beispielsweise zur Beschleunigung der chemischen Reaktion, bei der es sich auch um eine Polymerisation handeln kann, die Gesamtschicht mit energiereicher Strahlung, insbesondere mit UV-Licht, bestrahlt wird.

Erfindungsgemäß kann vorgesehen sein, dass die Trägerschicht, bevor sie abschnittsweise mit Tinte bedeckt wird, bereits auf dem Sieb, insbesondere einem Rund- oder Flachsieb, aufgebracht ist. Auf diese Weise ist das Sieb bereits nach dem Ausspülen der Gesamtschicht schon einsatzbereit.

Es kann aber auch vorgesehen sein, dass entsprechend der eingangs beschriebenen indirekten Methode die Trägerschicht sich während des Auftragens der Tinte noch auf einer separaten Folie befindet und erst nach Fertigstellung der Siebdruckschablone diese unter leichtem Druck auf das Siebgewebe aufgebracht wird. Da die Gesamtdicke einer Siebdruckschablone möglichst gering ausfallen sollte, um später ein optimales Druckergebnis zu erhalten, und erfindungsgemäß neben der Trägerschicht auch eine weitere Schicht, nämlich die Schicht aus Tinte, unbedingt erforderlich ist, ist es von Vorteil, wenn die Trägerschicht möglichst dünn ausfällt. Dabei muss allerdings berücksichtigt werden, dass die Tinte nur dann optimal auf die Trägerschicht aufgetragen werden kann, wenn diese eine glatte Oberfläche aufweist. Die Dicke und die Zusammensetzung der Trägerschicht muss also so gewählt werden, dass insbesondere dann, wenn die Trägerschicht vor dem Auftragen der Tinte bereits auf dem Sieb aufgebracht ist, sich nicht die Struktur des Siebes durch die Trägerschicht hindurchdrückt. Letzteres könnte nämlich zu einer ungleichmäßigen Verteilung der Tinte auf der Trägerschicht führen, was letztlich wiederum die Qualität der Siebdruckschablone negativ beeinflussen kann.

Eine aus dem Stand der Technik bekannte Vorrichtung zur Herstellung einer Siebdruckschablone für ein Sieb, insbesondere ein Rund- oder Flachsieb, mit einer Einrichtung zum Aufbringen einer Maske auf eine Trägerschicht ist erfindungsgemäß, insbesondere zur Verwirklichung des zuvor beschriebenen erfindungsgemäßen Verfahrens dadurch weitergebildet, dass die Maske zumindest im wesentlichen aus Tinte besteht. Diese erfindungsgemäße Vorrichtung gewährleistet die Verwirklichung der im Hinblick auf das erfindungsgemäße Verfahren beschriebenen Vorteile. Von besonderem Vorteil ist es demgemäss, wenn die Einrichtung zum Aufbringen der Maske in Form von Tinte eine EDV-Steuerung und insbesondere mindestens einen Druckkopf mit mehreren Düsen zum Aufspritzen der Tinte aufweist.

Gemäß einer vorteilhaften Ausgestaltung der erfindungsgemäßen Vorrichtung kann vorgesehen sein, dass sie eine separate Aufnahme für ein Sieb, insbesondere ein Rund- oder Flachsieb, aufweist. Auf diese Weise wird die Siebdruckschablone unmittelbar auf dem Sieb gefertigt, in dem auf das Sieb zunächst eine Trägerschicht aufgebracht wird und anschließend über die Einrichtung zum Aufbringen einer Maske Tinte aufgetragen wird. Stattdessen ist es aber auch denkbar, dass die Siebdruckschablone mittels der erfindungsgemäßen Vorrichtung auf einer Folie gefertigt wird und diese anschließend im fertigen Zustand auf das Sieb aufgebracht wird.

Nachfolgend wird die Erfindung anhand von Ausführungsbeispiele zeigenden Zeichnungen erläutert. Es zeigen
- Fig. 1: eine schematische Ansicht eines fertigen Flachsiebs,
- Fig. 2: eine Querschnittsdarstellung einer Schablone während ihrer Herstellung und
- Fig. 3: eine Querschnittsdarstellung einer fertigen Schablone.

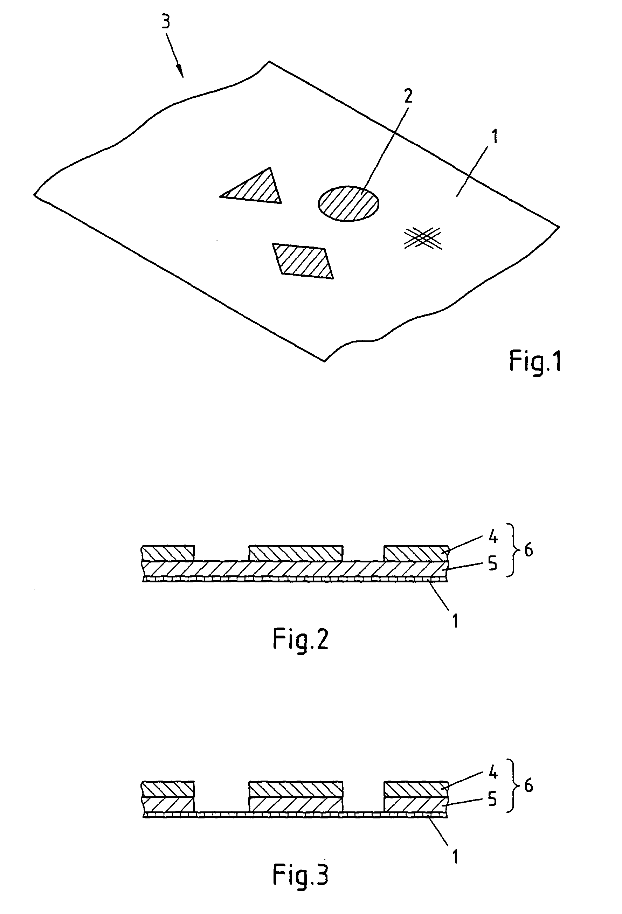

Fig. 1 zeigt ein Sieb 3 umfassend ein Siebgewebe 1 und eine mehrteilige Schablone 2. Über das Sieb 3, es handelt sich hierbei um ein Flachsieb, läuft während des Siebdruckverfahrens eine scharfkantige Gummirakel, die die Farbe über die gesamte Siebfläche schiebt. An den durchlässigen Stellen des Siebes kann die Druckfarbe auf die darunter befindliche, zu bedruckende Oberfläche, durchtreten. An den von der Schablone 2 abgedeckten Stellen tritt keine Farbe durch das Siebgewebe 1.

Fig. 2 zeigt ein Ausführungsbeispiel einer erfindungsgemäßen Schablone 2 im Querschnitt während ihrer Herstellung. Auf ein Siebgewebe 1 ist zunächst eine Trägerschicht 5 aufgebracht worden, die wiederum mittels einer Einrichtung zum Aufbringen einer Maske 4, die Bestandteil einer Vorrichtung zur Herstellung einer Siebdruckschablone 2 ist, abschnittsweise mit Tinte beschichtet worden ist.

Durch chemische Reaktion verbindet sich die Maske 4 aus Tinte automatisch mit der Trägerschicht 5 zu einer festen Gesamtschicht, die die fertige Schablone 2 bildet. Eine Polymerisation wie beim Stand der Technik ist nicht erforderlich.

Fig. 3 zeigt die fertige Schablone 2 im Querschnitt, nachdem die Gesamtschicht 6 durch Waschen ausgespült worden ist, d.h. die nicht ausgehärteten Abschnitte der Trägerschicht 5 entfernt worden sind. Das Sieb 3 ist nun für den Druckvorgang einsatzbereit.

## Patentansprüche

1. Verfahren zur Herstellung einer Siebdruckschablone (2) für ein Sieb (3), insbesondere für ein Rund- oder Flachsieb, bei welchem eine Maske (4) auf eine Trägerschicht (5) aufgebracht wird,
**dadurch gekennzeichnet, dass** die Maske (4) zumindest im wesentlichen aus Tinte hergestellt wird, dass die Tinte abschnittsweise auf die Trägerschicht (5) aufgetragen wird, wobei sich die Maske (4) aus Tinte mit der Trägerschicht (5) durch chemische Reaktion zu einer festen Gesamtschicht (6) verbindet, und das nach dem Verbinden die Gesamtschicht (6) durch Waschen ausgespült wird.

2. Verfahren nach Anspruch 1,
**dadurch gekennzeichnet, dass** die Tinte EDV-gestützt aus mehreren Düsen aufgespritzt wird.

3. Verfahren nach Anspruch 1 oder 2,
**dadurch gekennzeichnet, dass** die chemische Reaktion eine Polymerisation ist.

4. Verfahren nach einem der Ansprüche 1 bis 3,
**dadurch gekennzeichnet, dass** die chemische Reaktion unter energiereicher Strahlung, insbesondere UV-Bestrahlung, stattfindet.

5. Verfahren nach einem der Ansprüche 1 bis 4,
**dadurch gekennzeichnet, dass** die Trägerschicht (5) auf ein Sieb (3), insbesondere ein Rund- oder Flachsieb, aufgebracht ist.

6. Verfahren nach einem der Ansprüche 1 bis 5,
**dadurch gekennzeichnet, dass** die Trägerschicht (5) eine glatte Oberfläche aufweist.

7. Vorrichtung zur Herstellung einer Siebdruckschablone (2) mit einer Einrichtung zum Aufbringen einer Maske (4) auf eine Trägerschicht (5), insbesondere zur Verwirklichung eines Verfahren nach einem der Ansprüche 1 bis 6,
**dadurch gekennzeichnet, dass** die Maske (4) zumindest im wesentlichen aus Tinte besteht.

8. Vorrichtung nach Anspruch 7,
**dadurch gekennzeichnet, dass** die Einrichtung zum Aufbringen der Maske (4) eine EDV-Steuerung aufweist.

9. Vorrichtung nach Anspruch 7 oder 8,
**dadurch gekennzeichnet, dass** die Einrichtung zum Aufbringen der Maske (4) mindestens einen Druckkopf mit mehreren Düsen zum Aufspritzen der Tinte auf die Trägerschicht (5) aufweist.

10. Vorrichtung nach einem der Ansprüche 7 bis 9,
**dadurch gekennzeichnet, dass** die Vorrichtung eine Aufnahme für ein Sieb (3), insbesondere ein Rund- oder Flachsieb, aufweist.

11. Sieb (3), insbesondere Rund- oder Flachsieb, mit einer Siebdruckschablone (2)
**dadurch gekennzeichnet, dass** die Siebdruckschablone (2) aus einer festen, aus einer Trägerschicht (5) und einer damit verbundenen Tintenschicht (4) gebildeten Gesamtschicht (6) besteht.

12. Sieb nach Anspruch 11,
**dadurch gekennzeichnet, dass** die Verbindung der Trägerschicht (5) mit der Schicht (4) aus Tinte durch chemische Reaktion, insbesondere durch Polymerisation erfolgt ist.

13. Sieb nach Anspruch 11 oder 12,
**dadurch gekennzeichnet, dass** die Trägerschicht (5) eine glatte Oberfläche aufweist.
